# EUROPEAN PATENT APPLICATION

(11) **EP 4 151 783 A1**
(43) Date of publication of application: **22.03.2023**
(21) Application number: 21803639.0
(22) Date of filing: 07.05.2021
(51) Int. Cl.: C30B 25/18, C23C 16/30, C23C 16/42, C30B 29/38, H01L 21/02, H01L 21/20, H01L 21/31, H01L 27/12

(54) **BASE SUBSTRATE FOR GROUP III-V COMPOUND CRYSTALS AND PRODUCTION METHOD FOR SAME**

(30) Priority: 11.05.2020 JP 2020083033; 24.06.2020 JP 2020108655
(71) Applicant: SHIN-ETSU CHEMICAL CO., LTD., Tokyo 1000005 (JP)
(72) Inventor: KUBOTA, Yoshihiro, Annaka-shi, Gunma 379-0195 (JP); NAGATA, Kazutoshi, Annaka-shi, Gunma 379-0195 (JP)
(74) Representative: Vossius & Partner Patentanwälte Rechtsanwälte mbB
(86) International application number: PCT/JP2021/017500
(87) International publication number: WO 2021/230148

(57) **Abstract**

A base substrate (1) for a group III-V compound crystal according to the present invention includes: a ceramic core layer (2); an impurity encapsulating layer (3) configured to encapsulate the ceramic core layer (2); a bonding layer (4) on the impurity encapsulating layer; and a processed layer (5) on the bonding layer. The impurity encapsulating layer (3) is a layer made of a composition represented by a composition formula SiOₓN_{y} (here, x = 0 to 2, y = 0 to 1.5, and x+y > 0), the bonding layer (4) is a layer made of a composition represented by a composition formula SiO_{x'}N_{y'} (here, x' = 1 to 2, and y' = 0 to 2), and the processed layer (5) is a seed crystal layer. According to the present invention, it is possible to provide the base substrate for a group III-V compound crystal and a method for producing the same for obtaining a group III-V compound crystal having a large diameter and high quality.

## Description

### Technical Field

The present invention relates to a base substrate for a group III-V compound crystal and a method for producing the same.

### Background Art

A group III-V crystal substrate, in particular, a GaN-based crystal substrate or an AlN-based crystal substrate, has a wide band gap, and is excellent in terms of light emission property in a very short wavelength range and high breakdown voltage performance. Therefore, the GaN-based crystal substrate or the AlN-based crystal substrate is expected to be applied to devices such as a laser, a Schottky diode, a power device, and a high-frequency device.

However, at present, it is difficult to prepare a thick (long) crystal of a group III-V compound having a large diameter and high quality. For example, (i) in a case of growing a GaN crystal by a bulk growth method, since the GaN crystal is generally grown in high temperature liquid ammonia, a high temperature and high pressure device is essential, and therefore an increase in size of the GaN crystal and a reduction in production cost of the GaN crystal are inhibited. On the other hand, (ii) in a case of growing a GaN crystal by a vapor deposition method, since a difference in thermal expansion coefficient between the GaN crystal and a seed crystal substrate made of sapphire, SiC, or Si, or between the GaN crystal and a base substrate to which the seed crystal is attached is large, as the diameter or the thickness (length) of the GaN crystal is increased, a large thermal stress is generated, and the GaN crystal is likely to be largely warped or cracked. For this reason, at present even in a Si substrate (GaN On Si substrate) on which a GaN thin film having the largest large diameter of GaN is formed, the limit of the diameter of GaN is 6 inches. In addition, the GaN thin film formed on the Si substrate has a poor breakdown voltage. For the same reason, there is a situation that a thick film product for high breakdown voltage can only be produced with a small diameter of about 2 inches. Under such a background described above, the GaN-based crystal substrate or the AlN-based crystal substrate used in the above-described device is inevitably thin (low-breakdown-voltage product) at a high cost, and thus application expansion and wide popularization of the GaN-based crystal substrate or the AlN-based crystal substrate is inhibited.

As a countermeasure against the above, for example, related-art techniques described in PTL 1 and PTL 2 are known. For example, in a method described in PTL 1, a mullite based ceramic having substantially the same thermal expansion coefficient as that of the GaN crystal is used as a support substrate (base substrate). Accordingly, warpage or cracks are less likely to occur in the resulting GaN crystal. However, impurities in the mullite based ceramic serving as the support substrate diffuse in steps such as a seed crystal bonding step and a GaN growing step, and a high-quality GaN crystal cannot be obtained.

On the other hand, in a method described in PTL 2, an inexpensive AlN ceramic substrate having a thermal expansion coefficient relatively close to that of the GaN substrate is used. In order to prevent diffusion of impurities from the AlN ceramic substrate, the AlN ceramic substrate is sealed (wrapped) with a multilayer film SiO₂/Poly-Si/SiO₂/Si₃N₄. Si<111> having a lattice constant relatively close to that of GaN is attached as a seed crystal to an upper surface of the multilayer film via a thick film SiO₂, and a GaN single crystal is grown on the seed crystal by MOCVD, HVPE or the like to obtain a GaN epitaxial substrate or a solid substrate having a large diameter.

However, in this method, for example, in order to prevent the diffusion of the impurities, the AlN ceramic substrate is first wrapped with a SiO₂ film as an adhesive layer. Thereafter, the AlN ceramic substrate is further encapsulated with a Poly-Si film which also serves as an electrostatic chuck. Then, the AlN ceramic substrate is again wrapped with a SiO₂ film as an adhesive layer, and the AlN ceramic substrate is further encapsulated with a Si₃N₄ film as an impurity diffusion prevention layer. In this way, it is necessary to form as many as four engineering layers, which are cumbersome, and various expensive film forming devices for forming these layers are required. Therefore, the production cost of the GaN substrate is increased.

More specifically, an average thermal expansion coefficient of the AlN ceramic, which is a core of the base substrate, is 4.6 ppm/K to 5.2 ppm/K. An AlN core is encapsulated with a multilayer film composed of 3 to 4 layers made of inorganic compounds having chemical properties and an average thermal expansion coefficient greatly different from those of the AlN core. Further, even in the multilayer film, thermal expansion coefficients between layers are in a mixed state in which the thermal expansion coefficients are different from each other.

That is, the base substrate has a layer structure including AlN ceramic (4.6 ppm/K to 5.2 ppm/K)/SiO₂ (0.5 ppm/K)/Poly-Si (3.6 ppm/K)/SiO₂ (0.5 ppm/K)/Si₃N₄(3 ppm/K), two adjacent layers have chemical properties and average thermal expansion coefficients greatly different from each other, and the average thermal expansion coefficients of the layers are not smoothly uniform. Therefore, affinity between the layers is low, a large thermal stress is generated, and interlayer peeling, crack of the layers, and even warpage of the entire multilayer film or the like are likely to occur.

In other words, since the respective layers have completely different chemical compositions and have steps isolated from each other in average thermal expansion coefficient, the affinity and integrity between the respective layers are extremely weak in cooperation with the above-mentioned thermal stress. Therefore, the base substrate has a structure in which interlayer peeling or cracks are likely to occur. In addition, warpage or the like due to poor stress balance of the entire multilayer film is also likely to occur.

As a result, the engineering layer mainly intended to prevent impurity diffusion does not play the role of impurity diffusion, and there is a concern that impurities such as metals, oxygen, and carbon in the AlN ceramic diffuse into and contaminate the GaN substrate through cracks, peeling and the like generated in the entire base substrate. In addition, during the following series of steps after encapsulating (wrapping) with the engineering layer, specifically, during steps such as (i) a step of forming a thick film SiO₂ on the upper surface of the engineering layer, (ii) a step of heat-treating the thick film SiO₂, (iii) a step of polishing the thick film SiO₂ to smooth the surface of the thick film SiO₂, and (iv) a step of attaching a seed crystal Si<111> on the polished and smoothed surface of the thick film SiO₂, there is a concern that peeling, cracking, warping and the like frequently occur between the engineering layer, the thick film SiOz layer, and a Si<111> layer and in the respective layers. It is considered that the cause is that, in addition to the above-described problems of the engineering layer, there is no affinity between the engineering layer, the thick film SiO₂ layer, and the Si<111> layer, and a large thermal stress is generated between the thick film SiO₂ layer having an extremely small thermal expansion coefficient and the engineering layer or the Si<111> layer having an extremely large thermal expansion coefficient. Therefore, there is a strong demand for an improvement measure against these problems.

### Citation List

### Patent Literature

PTL 1: JP 2013-177285 A
PTL 2: JP 2019-523994 T

### Summary of Invention

### Technical Problem

The present invention has been made in view of the above-mentioned circumstances, and as a result of intensive studies to eliminate these disadvantages, the present invention has been completed as follows. That is, it is intended to provide a base substrate for a group III-V compound crystal and a method for producing the same for obtaining a group III-V compound crystal having a large diameter and high quality.

### Solution to Problem

In order to achieve the above-mentioned object, the present invention provides a base substrate for a group III-V compound crystal and a method for producing the same. That is:
[1] A base substrate for a group III-V compound crystal, including: a ceramic core layer; an impurity encapsulating layer configured to encapsulate the ceramic core layer; a bonding layer on the impurity encapsulating layer; and a processed layer on the bonding layer, in which the impurity encapsulating layer is a layer made of a composition represented by a composition formula SiOₓN_{y} (here, x = 0 to 2, y = 0 to 1.5, and x+y > 0), the bonding layer is a layer made of a composition represented by a composition formula SiO_{x'}N_{y'} (here, x' = 1 to 2, and y' = 0 to 2), and the processed layer is a seed crystal layer.
[2] The base substrate for a group III-V compound crystal according to the above [1], in which the ceramic core layer is a polycrystalline AlN layer, and the group III-V compound is a compound containing N and at least one group III element selected from the group consisting of Al, Ga, and In.
[3] The base substrate for a group III-V compound crystal according to the above [1] or [2], in which values of x and y in the composition formula SiOₓN_{y} of the impurity encapsulating layer is different between a ceramic core layer side and a bonding layer side.
[4] The base substrate for a group III-V compound crystal according to any one of the above [1] to [3], in which values of x' and y' in the composition formula SiO_{x'}N_{y'} of the bonding layer is different between an impurity encapsulating layer side and a processed layer side.
[5] The base substrate for a group III-V compound crystal according to any one of the above [1] to [4], in which the processed layer is a seed crystal made of at least one substance selected from the group consisting of Si, GaAs, SiC, AlN, GaN, and Al₂O₃.
[6] A method for producing a base substrate for a group III-V compound crystal, including: a step of forming an impurity encapsulating layer configured to encapsulate a ceramic core layer; a step of forming a bonding layer on the impurity encapsulating layer; and a step of forming a processed layer on the bonding layer, in which the impurity encapsulating layer is a layer made of a composition represented by a composition formula SiOₓN_{y} (here, x = 0.0 to 2.0, and y = 0.0 to 1.5), the bonding layer is a layer made of a composition represented by a composition formula SiO_{x'}N_{y'} (here, x' = 1.0 to 2.0, and y' = 0.0 to 2.0), and the processed layer is a seed crystal layer.
[7] The method for producing a base substrate for a group III-V compound crystal according to the above [6], in which in the step of forming the processed layer, a seed crystal substrate is transferred to the bonding layer, and then the substrate is peeled off to form the processed layer.
[8] The method for producing a base substrate for a group III-V compound crystal according to the above [6] or [7], in which the ceramic core layer is a polycrystalline AlN layer, and the group III-V compound is a compound containing N and at least one group III element selected from the group consisting of Al, Ga, and In.
[9] The method for producing a base substrate for a group III-V compound crystal according to any one of the above [6] to [8], in which in the step of forming the impurity encapsulating layer, the impurity encapsulating layer is formed such that values of x and y in the composition formula SiOₓN_{y} of the impurity encapsulating layer are different between a ceramic core layer side and a bonding layer side.
[10] The method for producing a base substrate for a group III-V compound crystal according to any one of the above [6] to [9], in which in the step of forming the bonding layer, the bonding layer is formed such that values of x' and y' in the composition formula SiO_{x'}N_{y'} of the bonding layer are different between an impurity encapsulating layer side and a processed layer side.
[11] The method for producing a base substrate for a group III-V compound crystal according to any one of the above [6] to [10], further including: a step of thermally stabilizing at least one of the ceramic core layer, the impurity encapsulating layer, and the bonding layer; and a step of polishing a surface of the thermally stabilized layer.
[12] The method for producing a base substrate for a group III-V compound crystal according to any one of the above [6] to [11], in which in the step of forming the processed layer, the processed layer is formed by performing ion implantation on a seed crystal substrate made of at least one substance selected from the group consisting of Si, GaAs, SiC, AlN, GaN, and Al₂O₃, transferring the substrate subjected to the ion implantation to the bonding layer, and peeling off the transferred substrate.

### Advantageous Effects of Invention

According to the present invention, it is possible to provide a base substrate for a group III-V compound crystal and a method for producing the same for obtaining a group III-V compound crystal having a large diameter and high quality.

### Brief Description of Drawings

Fig. 1 is a view illustrating a base substrate for a group III-V compound crystal according to one embodiment of the present invention.
Fig. 2 is a view illustrating a step (C) in a method for producing the base substrate for a group III-V compound crystal according to the embodiment of the present invention.

### Description of Embodiments

### [Base Substrate for Group III-V Compound Crystal]

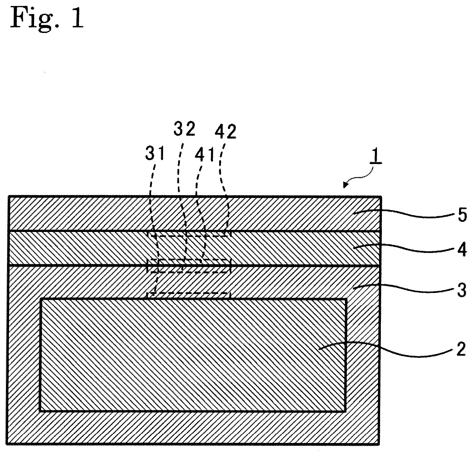

Hereinafter, a base substrate for a group III-V compound crystal according to one embodiment of the present invention will be described with reference to Fig. 1.

A base substrate 1 for a group III-V compound crystal according to the embodiment of the present invention includes: a ceramic core layer 2; an impurity encapsulating layer 3 configured to encapsulate the ceramic core layer 2; a bonding layer 4 on the impurity encapsulating layer; and a processed layer 5 on the bonding layer 4.

### (Ceramic Core Layer)

The ceramic core layer 2 is a layer serving as a base of the base substrate 1 for a group III-V compound crystal according to the embodiment of the present invention. The ceramic core layer 2 is preferably made of a material having a thermal expansion coefficient close to a thermal expansion coefficient of the group III-V compound to be prepared. From the viewpoint that the ceramic core layer 2 having a large diameter can be easily prepared, the ceramic core layer 2 is preferably a layer made of a polycrystalline ceramic material. Examples of the polycrystalline ceramic material constituting the ceramic core layer 2 include polycrystalline aluminum nitride (AlN), polycrystalline gallium nitride (GaN), polycrystalline aluminum gallium nitride (AlGaN), polycrystalline silicon carbide (SiC), polycrystalline zinc oxide (ZnO), and polycrystalline gallium trioxide (Ga₂O₃). Among these, polycrystalline aluminum nitride (AlN) is preferable, and polycrystalline aluminum nitride (AlN) containing a sintering aid such as aluminum oxide or yttrium oxide is more preferable, from the viewpoint of obtaining the ceramic core layer 2 having a large diameter at a relatively low cost.

From the viewpoint of securing strength of the base substrate 1 for a group III-V compound crystal and from the viewpoint of handleability of the base substrate 1 for a group III-V compound crystal, the thickness of the ceramic core layer 2 is, for example, 100 µm to 1,500 µm. In addition, from the viewpoint of obtaining the base substrate 1 for a group III-V compound crystal having a large diameter with excellent breakdown voltage performance, the diameter of the ceramic core layer 2 is 150 mm or more.

### (Impurity Encapsulating Layer)

The impurity encapsulating layer 3 encapsulates the ceramic core layer 2 and prevents diffusion of impurities in the ceramic core layer. The impurity encapsulating layer 3 is a layer made of a composition represented by a composition formula SiOₓN_{y} (here, x = 0 to 2, y = 0 to 1.5, and x+y > 0). Accordingly, the impurity encapsulating layer 3 can obtain good affinity with the ceramic core layer 2, and can more effectively prevent the diffusion of impurities from the ceramic core layer 2.

The composition represented by the composition formula SiOₓN_{y} is generally a mixed composition containing (i) a SiOz component, (ii) a component composed of (Si, O, N) (for example, a Si₂N₂O component), and (iii) a Si₃N₄ component. The composition represented by the composition formula SiOₓN_{y} optionally contains a trace amount of H, but H is not shown in the formula SiOₓN_{y} in the present description. That is, the composition represented by the composition formula SiOₓN_{y} includes a composition containing a trace amount of H. In addition, the composition represented by the composition formula SiOₓN_{y} is not limited to a mixed composition including single stoichiometric compounds, and may be a mixed composition including a non-stoichiometric compound in which a ratio of Si, O, and N atoms does not conform to the law of constant proportion.

In the composition formula SiOₓN_{y} of the impurity encapsulating layer 3, when x+y = 0, that is, x = 0 and y = 0, the affinity of the impurity encapsulating layer 3 with the ceramic core layer 2 is extremely weak. When x = 0 and y > 1.5, since the Si₃N₄ component having high rigidity increases, the impurity encapsulating layer 3 cannot follow a thermal strain of the ceramic core layer 2 having high rigidity, and layer separation or the like is likely to occur. On the other hand, when x > 2.0 and y = 0, since the SiOz component is a main component, the affinity of the impurity encapsulating layer 3 with the ceramic core layer 2 is improved, but the strength of the impurity encapsulating layer 3 is reduced, and layer separation is likely to occur. In addition, since an amount of the Si₃N₄ component is small, an impurity diffusion prevention function, which is a feature of the Si₃N₄ component, is hardly exhibited, and various impurities from the ceramic core layer or an external environment are easily mixed into the bonding layer 4 or the processed layer 5. When x > 2.0 and y > 1.5, since an amount of the O component is larger than that of Si and N, an amount of the SiO₂ component is larger than that of the Si₃N₄ component, the moisture resistance of the impurity encapsulating layer 3 deteriorates, and further, the "extremely small thermal expansion coefficient" of the SiO₂ component is largely exhibited in the impurity encapsulating layer 3, so that a difference in thermal expansion coefficient between the impurity encapsulating layer 3 and the ceramic core layer 2 is large, and the affinity and the integrity with the ceramic core layer 2 cannot be maintained in some cases. As a result, characteristics of the base substrate 1 for a group III-V compound crystal deteriorate.

Values of x and y in the composition formula SiOₓN_{y} of the impurity encapsulating layer 3 are preferably different between a ceramic core layer side and a bonding layer side. Accordingly, the impurity encapsulating layer 3 can further obtain good affinity with the ceramic core layer 2, and can further prevent the diffusion of impurities from the ceramic core layer 2. For example, by appropriately changing an atomic ratio of Si, O, and N in the impurity encapsulating layer 3 from the ceramic core layer side toward the bonding layer side, the difference in thermal expansion coefficient can be reduced while maintaining the affinity and the integrity between the impurity encapsulating layer 3 and the ceramic core layer 2, and the difference in thermal expansion coefficient can be reduced while maintaining the affinity and the integrity between the impurity encapsulating layer 3 and the bonding layer 4.

It is preferable to gradually change a composition of the impurity encapsulating layer 3 from the ceramic core layer side toward the bonding layer side, that is, from the ceramic core layer side toward an outer side. That is, the composition of the impurity encapsulating layer 3 is preferably a gradient composition (gradation). Accordingly, it is possible to bring the thermal expansion coefficient of a region in the impurity encapsulating layer 3 near the ceramic core layer 2 close to the thermal expansion coefficient of the ceramic core layer 2, and to bring the thermal expansion coefficient of a region in the impurity encapsulating layer 3 near the bonding layer 4 close to the thermal expansion coefficient of the bonding layer 4, while maintaining the affinity and the integrity between the impurity encapsulating layer 3 and the ceramic core layer 2 and the affinity and the integrity between the impurity encapsulating layer 3 and the bonding layer 4. As a result, the impurity encapsulating layer 3 does not have a clear step in which compositions of the respective layers are completely different from each other and the thermal expansion coefficients of the respective layers are greatly isolated from each other, as in the related invention described in PTL 2. Therefore, as a smoothly uniform composition, the impurity encapsulating layer 3 can maintain the affinity and the integrity and can prevent generation of thermal stress in the impurity encapsulating layer 3. In addition, an occurrence of peeling or cracking in the impurity encapsulating layer and warpage of the impurity encapsulating layer 3 is prevented. Specifically, for example, it is preferable that, in the composition formula SiOₓN_{y} of the impurity encapsulating layer 3, the value of x gradually decreases and the value of y gradually increases from the ceramic core layer side toward the bonding layer side.

When the values of x and y in the composition formula SiOₓN_{y} of the impurity encapsulating layer 3 are different between the ceramic core layer side and the bonding layer side, from the viewpoint of affinity and integrity between the impurity encapsulating layer 3 and the ceramic core layer 2, in a region 31 in near the ceramic core layer 2, it is preferable that the value of x is 0.8 to 2.0 and the value of y is 0.0 to 1.2, and it is more preferable that the value of x is 1.0 to 1.8 and the value of y is 0.2 to 1.0 in the composition formula SiOₓN_{y} of the impurity encapsulating layer 3. In addition, in a region 32 outside the impurity encapsulating layer 3, from the viewpoint of preventing impurity diffusion, it is more preferable that the value of x is 0.0 to 0.7 and the value of y is 0.8 to 1.5, and it is more preferable that the value of x is 0.2 to 0.5, and the value of y is 1.0 to 1.4 in the composition formula SiOₓN_{y} of the impurity encapsulating layer 3. In this case, from the viewpoint of preventing peeling and cracking in the impurity encapsulating layer 3, the composition of the impurity encapsulating layer 3 is preferably a gradient composition (gradation).

The thickness of the impurity encapsulating layer 3 is preferably a thickness sufficient to maintain the affinity with the ceramic core layer 2, to be integrated with the ceramic core layer 2, and to prevent impurity diffusion in the ceramic core layer. From such a viewpoint, the thickness of the impurity encapsulating layer 3 is generally 3 µm or less, and preferably 0.5 µm to 2.0 um. When the thickness of the impurity encapsulating layer 3 is 0.5 µm or more, diffusion of impurities can be sufficiently prevented. When the thickness of the impurity encapsulating layer 3 is 2.0 µm or less, an occurrence of warpage due to the difference in thermal expansion coefficient between the impurity encapsulating layer 3 and the ceramic core layer 2 can be prevented.

The impurity encapsulating layer 3 can be formed by supplying source gases such as SiH₄, SiH₂Cl₂, O₂, NH₃, and N₂O using a device such as a general low pressure chemical vapor deposition (LPCVD) device or plasma device. In addition, the impurity encapsulating layer 3 can have the gradient composition (gradation) by supplying the source gas while gradually changing a ratio of the source gases such as SiH₄, SiH₂Cl₂, O₂, NH₃, and N₂O. A device for forming the impurity encapsulating layer 3 is preferably an LPCVD device, and the source gas is preferably SiH₄, O₂, NH₃, and N₂O.

### (Bonding Layer)

The bonding layer 4 is a layer made of a composition represented by a composition formula SiO_{x'}N_{y'} (here, x' = 1 to 2, y' = 0 to 2) on the impurity encapsulating layer. The composition represented by the composition formula SiO_{x'}N_{y'} is also generally a mixed composition containing (i) a SiO₂ component, (ii) a component composed of (Si, O, N) (for example, a Si₂N₂O component), and (iii) a Si₃N₄ component. The composition represented by the composition formula SiO_{x'}N_{y'} also contains a trace amount of H in some cases, but H is not shown in the composition formula SiO_{x'}N_{y'} in the present description. That is, the composition represented by the composition formula SiO_{x'}N_{y'} includes a composition containing a trace amount of H. In addition, the composition represented by the composition formula SiO_{x'}N_{y'} is not limited to a mixed composition including single stoichiometric compounds, and may be a mixed composition including a non-stoichiometric compound in which a ratio of Si, O, and N atoms does not conform to the law of constant proportion.

In the composition formula SiO_{x'}N_{y'} of the bonding layer 4, when x' < 1 and y' = 0, the bonding layer 4 is mainly composed of the SiO₂ component, and thus has a high affinity with the impurity encapsulating layer 3, but a void defect due to degassing and dehydration is likely to occur. When x' < 1.0 and y' > 2.0, the Si₃N₄ component having high rigidity and high hardness is increased in the bonding layer 4, and thus the cost of a subsequent step such as polishing is increased. On the other hand, when x' > 2.0 and y' = 0, the bonding layer 4 is mainly composed of the SiO₂ component, and thus polishing is easy but the strength is low, causing a difficulty in smoothing. In addition, since the Si₃N₄ component having a high impurity diffusion prevention function hardly exists in the bonding layer 4, various impurities from the ceramic core layer or an external environment are easily diffused into the processed layer 5. When x' > 2.0 and y' > 2.0, an unstable component is likely to be formed at a non-stoichiometric ratio of SiON, and the affinity and the integrity are improved, but the moisture resistance may be reduced.

Values of x' and y' in the composition formula SiO_{x'}N_{y'} of the bonding layer 4 are preferably different between a impurity encapsulating layer side and a processed layer side. Accordingly, it is possible to reduce the difference in thermal expansion coefficient between the bonding layer 4 and the impurity encapsulating layer 3 while maintaining the affinity and the integrity therebetween, and to reduce the difference in thermal expansion coefficient between the bonding layer 4 and the processed layer 5 while maintaining the affinity and the integrity therebetween. Then, interlayer peeling, cracking, and warpage do not occur.

When the values of x' and y' in the composition formula SiO_{x'}N_{y'} of the bonding layer 4 are different between the impurity encapsulating layer side and the processed layer side, from the viewpoint of affinity and integrity between the bonding layer 4 and the impurity encapsulating layer 3, in a region 41 near the impurity encapsulating layer 3, it is preferable that the value of x' is 1.0 to 1.8 and the value of y' is 1.0 to 2.0, and it is more preferable that the value of x' is 1.1 to 1.5 and the value of y' is 1.2 to 1.9 in the composition formula SiO_{x'}N_{y'} of the bonding layer 4. In a region 42 outside the bonding layer 4, from the viewpoint of affinity and integrity between the bonding layer 4 and the processed layer 5, in the composition formula SiO_{x'}N_{y'} of the bonding layer 4, it is preferable that the value of x' is 1.3 to 2.0 and the value of y' is 0.0 to 1.6, and it is more preferable that the value of x' is 1.5 to 1.8, and the value of y' is 0.2 to 1.4.

It is preferable to gradually change the composition of the bonding layer 4 from the impurity encapsulating layer side toward the processed layer side. That is, the composition of the bonding layer 4 is preferably a gradient composition (gradation). Accordingly, it is possible to bring the thermal expansion coefficient of a region in the bonding layer 4 near the impurity encapsulating layer 3 close to the thermal expansion coefficient of the impurity encapsulating layer 3, and to bring the thermal expansion coefficient of a region in the bonding layer 4 near the processed layer 5 close to the thermal expansion coefficient of the processed layer 5, while maintaining the affinity and the integrity between the bonding layer 4 and the impurity encapsulating layer 3 as well as the affinity and the integrity between the bonding layer 4 and the processed layer 5. Then, interlayer peeling, cracking, and warpage do not occur. Specifically, for example, it is preferable that, in the composition formula SiO_{x'}N_{y'} of the bonding layer 4, the value of x' gradually increases and the value of y' gradually decreases from the impurity encapsulating layer side toward the processed side.

The thickness of the bonding layer 4 is preferably a thickness sufficient to fill defects and voids in the ceramic core layer 2. In general, a ceramic substrate used as the ceramic core layer 2 in the base substrate for a group III-V compound crystal according to the embodiment of the present invention is ground and polished, and has a smooth surface. However, defects and voids generated during sintering still remain in the ceramic substrate. In general, the depth of the voids is about 4 µm at the maximum. Therefore, the thickness of the bonding layer 4 is preferably a thickness sufficient to fill these defects and voids. From such a viewpoint, the thickness of the bonding layer 4 is preferably 4.5 µm to 8.5 µm. When the thickness of the bonding layer 4 is 4.5 µm or more, the bonding layer 4 can sufficiently fill defects and voids, and it is possible to prevent a recess from being formed in the surface of the bonding layer 4. On the other hand, when the thickness of the bonding layer 4 is 8.5 µm or less, it is possible to prevent an increase in influence/cost due to an extra film formation cost.

Similar to the impurity encapsulating layer 3, the bonding layer 4 can also be formed by supplying source gases such as SiH₄, SiH₂Cl₂, O₂, NH₃, and N₂O using a device such as a general low pressure chemical vapor deposition (LPCVD) device or plasma device. In addition, similar to the impurity encapsulating layer 3, the bonding layer 4 can also have the gradient composition (gradation) by supplying the source gas while gradually changing a ratio of the source gases such as SiH₄, SiH₂Cl₂, O₂, NH₃, and N₂O. A device for forming the bonding layer 4 is preferably an LPCVD device, and the source gas is preferably SiH₄, O₂, NH₃, and N₂O.

### (Processed Layer)

The processed layer 5 is a seed crystal layer of the bonding layer. A group III-V compound is epitaxially grown on the processed layer 5. It is preferable that the seed crystal has a crystal form similar to and has a lattice constant relatively close to those of a crystal of the group III-V compound epitaxially grown on the processed layer 5, and can easily form a substrate having a large diameter. From such a viewpoint, the seed crystal is preferably Si, GaAs, SiC, AlN, GaN, and Al₂O₃, and more preferably Si<111>. In addition, from the viewpoint of easily obtaining a substrate having a large diameter, AlN and GaN are preferably formed by vapor deposition. For example, a large crystal for a seed crystal of AlN and GaN can be prepared by a vapor deposition method such as a metal organic chemical vapor deposition (MOCVD) method, a hydride vapor phase epitaxy (HVPE) method, or a trihydride vapor phase epitaxy (THVPE) method.

The thickness of the processed layer 5 is preferably 200 nm to 1,000 nm. When the thickness of the processed layer 5 is 200 nm or more, it is possible to reduce a ratio of a portion damaged by ion implantation in the processed layer 5, and it is easy to form a high-quality seed crystal on the bonding layer 4. When the thickness of the processed layer 5 is 1,000 nm or less, it is possible to prevent an occurrence of defects or cracks in the crystal of the group III-V compound due to the difference in thermal expansion coefficient between the processed layer 5 and the crystal of the group III-V compound epitaxially grown on the processed layer 5.

The processed layer 5 can be formed, for example, by performing ion implantation on a seed crystal substrate and then thin-film transferring an ion-implanted portion of the seed crystal substrate to the bonding layer 4, that is, by transferring the seed crystal substrate to the bonding layer 4 and then peeling off the seed crystal substrate. The ion implantation may be performed by a general method. The ion implantation is a method of ionizing atoms or molecules to be implanted in vacuum, accelerating the obtained ions from several keV to several MeV, and implanting the ions into a solid. Examples of the ions to be implanted include hydrogen ions and argon (Ar) ions. For example, an ion implantation device is used for the ion implantation. The ion implantation device is obtained by downsizing a high-energy accelerator and an isotope separator, and includes an ion source, an accelerator, a mass separator, a beam scanning unit, an implantation chamber and the like. The depth of an ion implantation region can be adjusted by an acceleration energy and an irradiation amount of the ions. The depth of the ion implantation region is preferably 200 nm to 1,000 nm, and more preferably 300 nm to 600 nm. When the depth of the ion implantation region is less than 200 nm, a ratio of a portion damaged by hydrogen ions or Ar ions in the seed crystal formed on the bonding layer increases, and the processed layer 5 may not be a good seed crystal layer. On the other hand, when the depth of the ion implantation region is larger than 1,000 nm, the seed crystal is too thick, the difference in thermal expansion coefficient between the crystal of the group III-V compound and the seed crystal formed thereon is large, and defects and cracks are likely to occur in the crystal of the group III-V compound, or the process is not economical in some cases. After the ion implantation is performed on the seed crystal substrate, chemical mechanical polishing (CMP) or etching is preferably performed on the seed crystal substrate in order to remove the portion damaged by the hydrogen ions or the Ar ions. After the thin-film transfer, a recovered remaining part of the seed crystal substrate is again ion-implanted for reuse as a seed crystal substrate to be subjected to thin-film transfer on the bonding layer.

### (Group III-V Compound Crystal)

A group III-V compound crystal can be formed by epitaxial growth on the base substrate 1 for a group III-V compound crystal according to the embodiment of the present invention by a vapor deposition method such as a metal organic chemical vapor deposition (MOCVD) method, a hydride vapor phase epitaxy (HVPE) method, or a trihydride vapor phase epitaxy (THVPE) method. Accordingly, a high-quality group III-V compound crystal having a large diameter and a thick film can be obtained. The group III-V compound is preferably a compound containing N and at least one group III element selected from the group consisting of Al, Ga, and In. Examples of the group III-V compound include GaN, AlN, AlₓGa_{1xX}N, InₓGa₁₋ₓN, and AlₓIn_{y}Ga_{1-x-y}N. Among these, the base substrate 1 for a group III-V compound crystal according to the embodiment of the present invention is particularly suitable for preparing GaN. Further, if necessary, the group III-V compound can contain a dopant such as Zn, Cd, Mg, or Si.

By peeling off the group III-V compound crystal formed on the base substrate 1 for a group III-V compound crystal according to the embodiment of the present invention, a self-supporting group III-V compound single crystal substrate having a large diameter and less contaminated by impurities can be prepared.

### [Method for Producing Base Substrate for Group III-V Compound Crystal]

A method for producing the base substrate for a group III-V compound crystal according to the embodiment of the present invention includes: (A) a step of forming an impurity encapsulating layer configured to encapsulate a ceramic core layer; (B) a step of forming a bonding layer on the impurity encapsulating layer; and (C) a step of forming a processed layer on the bonding layer. Accordingly, the base substrate for a group III-V compound crystal according to the embodiment of the present invention can be produced. Hereinafter, each step will be described in detail.

### (Step (A))

In the step (A), an impurity encapsulating layer configured to encapsulate a ceramic core layer is formed. The impurity encapsulating layer can be formed using a device such as a general low pressure chemical vapor deposition (LPCVD) device or a plasma device. Since the ceramic core layer and the impurity encapsulating layer are the same as those described in a section of the base substrate for a group III-V compound crystal according to the embodiment of the present invention, the description of the ceramic core layer and the impurity encapsulating layer will be omitted.

### (Step (B))

In the step (B), a bonding layer is formed on the impurity encapsulating layer. Similar to the impurity encapsulating layer, the bonding layer can also be formed using a device such as a general low pressure chemical vapor deposition (LPCVD) device or a plasma device. Since the bonding layer is the same as that described in a section of the base substrate for a group III-V compound crystal according to the embodiment of the present invention, the description of the bonding layer is omitted.

### (Step (C))

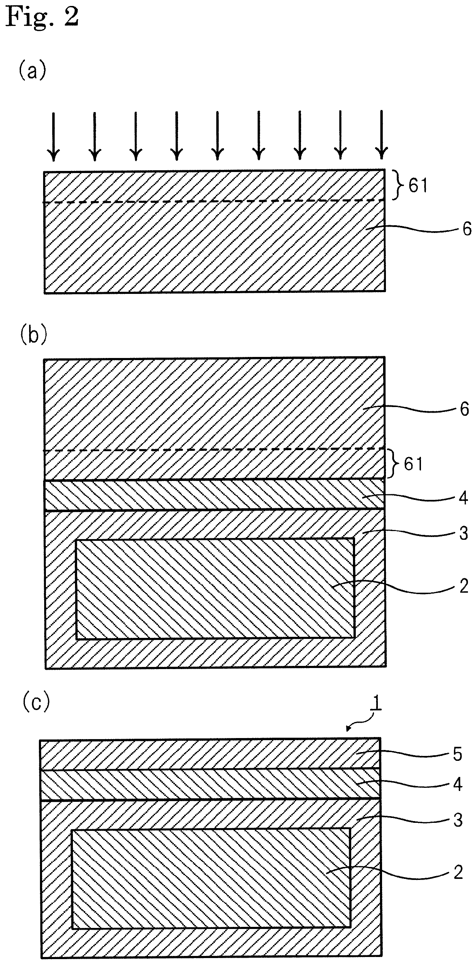

In the step (C), a processed layer is formed on the bonding layer. The processed layer can be formed by transferring a seed crystal substrate to the bonding layer and then peeling off the seed crystal substrate. Specifically, with reference to Fig. 2, ion implantation is performed on a seed crystal substrate 6 made of at least one substance selected from the group consisting of Si, GaAs, SiC, AlN, GaN, and Al₂O₃ to form an ion implantation layer 61 on the substrate 6 (see (a) of Fig. 2). The substrate 6 is transferred to the bonding layer 4 such that the ion implantation layer 61 is in contact with the bonding layer 4 (see (b) of Fig. 2). Then, the processed layer 5 can be formed by peeling off the transferred substrate 6 (see (c) of Fig. 2). Since the processed layer is the same as that described in a section of the base substrate for a group III-V compound crystal according to the embodiment of the present invention, the description of the processed layer is omitted.

### (Additional Steps)

The method for producing the base substrate for a group III-V compound crystal according to the embodiment of the present invention may further include a step of thermally stabilizing at least one of the ceramic core layer, the impurity encapsulating layer, and the bonding layer, and a step of polishing a surface of the thermally stabilized layer. For example, the method for producing the base substrate for a group III-V compound crystal according to the embodiment of the present invention may further include, before the step (A), a step of thermally stabilizing the ceramic core layer, and a step of polishing a surface of the thermally stabilized ceramic core layer. Accordingly, bonding strength between the ceramic core layer and the impurity encapsulating layer can be further improved. The method for producing the base substrate for a group III-V compound crystal according to the embodiment of the present invention may further include, between the step (A) and the step (B), a step of thermally stabilizing the impurity encapsulating layer and a step of polishing a surface of the thermally stabilized impurity encapsulating layer. Accordingly, adhesive strength between the impurity encapsulating layer and the bonding layer can be further improved. The method may further include, between the step (B) and the step (C), a step of thermally stabilizing the bonding layer and a step of polishing a surface of the thermally stabilized bonding layer. Accordingly, even when the density of the bonding layer increases and the bonding layer is thick, it is possible to withstand polishing and smoothing. In addition, adhesive strength between the bonding layer and the processed layer can be further improved.

In the thermal stabilization treatment, the layer is baked at a temperature of 1,000°C to 1,300°C, for example. The layer subjected to the thermal stabilization treatment is smoothed by, for example, chemical mechanical polishing (CMP).

The above description is merely an example, and the base substrate for a group III-V compound crystal according to the present invention and the method for producing the base substrate for a group III-V compound crystal according to the present invention are not limited to the above-mentioned embodiments. For example, in order to fix the base substrate for a group III-V compound crystal by an electrostatic chuck, a semiconductor film such as a P-Si film or a doped P-Si film may be formed as the lowermost layer of the base substrate for a group III-V compound crystal.

### Examples

Hereinafter, the present invention will be described in detail with reference to Examples and Comparative Examples, but the present invention is not limited to the following Examples.

### [Example 1]

A mixture obtained by mixing 100 parts by weight of AlN powder with 5 parts by weight of Y₂O₃ powder as a sintering aid was subjected to sheet-molding to form an AlN green sheet, and the AlN green sheet was cut into a disc shape having a diameter of about 230 mm to prepare a disc-shaped green sheet. The disc-shaped green sheet was baked in an N₂ atmosphere at a baking temperature of 1,850°C for 4 hours to prepare an AlN ceramic. The obtained AlN ceramic was further ground and polished to obtain a circular polycrystalline AlN ceramic substrate having a diameter of 200 mm and a thickness of 750 µm.

The polycrystalline AlN ceramic substrate (P-AlN ceramic substrate) was placed into an LPCVD device having a gas supply device for SiH₄, O₂, NH₃, and N₂O. Then, the P-AlN ceramic substrate was heated to 400°C, and then SiH₄, O₂, NH₃, and N₂O were supplied to start film formation. A ratio of SiH₄, O₂, NH₃, and N₂O at the start of the film formation was SiH₄/O₂/NH₃/N₂O = 10/20/1/1 in terms of molar ratio. The ratio of SiH₄, O₂, NH₃, and N₂O was uniformly and gradually changed for 30 minutes such that the ratio of SiH₄, O₂, NH₃, and N₂O at the end of the film formation was SiH₄/O₂/NH₃/N₂O = 10/1/10/10 in terms of molar ratio. Then, the P-AlN ceramic substrate was sealed with an impurity encapsulating layer (having a composition represented by the composition formula SiOₓN_{y}) having a film thickness of 800 nm.

When quantitative analysis of each element of the impurity encapsulating layer (having a composition represented by the composition formula SiOₓN_{y}) was performed, a region near the P-AlN ceramic substrate at the start of the film formation was a SiO_{1.8}N_{0.2} composition in which the amount of the SiO₂ component was large and the SiO₂ component and a small amount of Si₃N₄ component were mixed. A region outside the P-AlN ceramic substrate at the final stage of the film formation was a SiO_{0.2}N_{1.4} composition containing a small amount of SiO₂ component and containing a Si₃N₄ component as a main component. In a region between the two regions, the amount of the SiO₂ component gradually decreased and the amount of the Si₃N₄ component gradually increased with a lapse of film formation time. That is, the region between the two regions was a composition represented by a so-called gradated composition formula SiOₓN_{y}.

The P-AlN ceramic substrate was further heated to 500°C in the same LPCVD device, and then SiH₄, O₂, NH₃, and N₂O were supplied to start the film formation only on an upper surface of the P-AlN ceramic substrate. The ratio of SiH₄, O₂, NH₃, and N₂O at the start of the film formation was SiH₄/O₂/NH₃/N₂O = 10/1/10/10 in terms of molar ratio. The ratio of SiH₄, O₂, NH₃, and N₂O was uniformly and gradually changed for 3 hours such that the ratio of SiH₄, O₂, NH₃, and N₂O at the end of the film formation was SiH₄/O₂/NH₃/N₂O = 10/10/1/1 in terms of molar ratio. Then, a bonding layer (having a composition represented by the composition formula SiOₓN_{y}) having a film thickness of 5 µm was formed on the impurity encapsulating layer. The bonding layer having a film thickness of 5 µm completely filled voids caused by the P-AlN ceramic substrate.

In the same manner as in the impurity encapsulating layer, when quantitative analysis of each element of the bonding layer (having the composition represented by the composition formula SiOₓN_{y}) was performed, a region near the impurity encapsulating layer was a SiO_{1.1}N_{1.9} composition in which a Si₃N₄ component as a main component and a small amount of SiO₂ component were mixed. A region outside the impurity encapsulating layer at the final stage of the film formation was a SiO_{1.8}N_{0.2} composition containing a small amount of Si₃N₄ component and the SiO₂ component as a main component. In a region between the two regions, the amount of the Si₃N₄ component gradually decreased and the amount of the SiO₂ component gradually increased with a lapse of film formation time. That is, the region between the two regions was a composition represented by a so-called gradated composition formula SiO_{x'}N_{y'}.

After the bonding layer was formed on the impurity encapsulating layer, the bonding layer was baked at a heating temperature of 1,050°C for 5 hours to perform a thermal stabilization treatment on the bonding layer. Then, in order to facilitate thin-film transfer of a seed crystal substrate in a next step, a surface of the bonding layer was smoothed by CMP until the surface roughness satisfies Ra = 0.2 nm.

A Si<111> substrate having a diameter of 200 mm was selected as the seed crystal substrate to be thin-film transferred to the bonding layer. A general ion implantation device was used to implant H₂ ions into the Si<111> substrate at a dose of 5 × 10¹⁶ atom/cm² up to a depth of 500 nm. The Si<111> substrate subjected to the ion implantation was thin-film transferred to the bonding layer subjected to the thermal stabilization treatment and the polishing to form a processed layer having a thickness of 500 nm on the bonding layer, thereby producing a base substrate for a group III-V compound crystal according to Example 1 (see Fig. 1). The Si<111> substrate remaining after the peeling was recovered and reused as a seed crystal substrate for forming a processed layer.

The base substrate for a group III-V compound crystal according to Example 1 was a high-quality base substrate for a group III-V compound crystal having a large diameter, in which warpage, layer separation, cracks, etc. were not observed.

In order to evaluate the base substrate for a group III-V compound crystal according to Example 1, the following treatment was performed. First, in order to remove a damaged layer due to ion implantation on a surface of the Si<111>, the surface of the Si<111> substrate was removed to a depth of about 150 nm by an etching treatment. Next, a GaN epitaxial layer having a thickness of 35 µm was directly formed on the processed layer by an MOCVD device. At this time, in general GaN epitaxial film formation, 10 or more superlattice layers are stacked at the beginning of the film formation, and then a GaN epitaxial film is formed on the superlattice layer to reduce a stress between GaN and the Si<111> substrate. However, in this evaluation, the GaN epitaxial film was directly formed on the Si<111> processed layer. As a result, no peeling or cracking occurred in the epitaxial layer.

The GaN epitaxial layer prepared using the base substrate for a group III-V compound crystal according to Example 1 was peeled off from the base substrate for a group III-V compound crystal to prepare a self-supporting GaN epitaxial substrate. The GaN epitaxial substrate was used to experimentally produce a vertical transistor. When the breakdown voltage thereof was examined, a high breakdown voltage of 1,200 V was obtained. Previously, as described above, when a GaN epitaxial layer having a thickness of 10 µm or more was formed, warpage increased, and layer peeling or cracking occurred. Therefore, only a lateral low breakdown voltage transistor could be produced at best. This further shows a superiority of the base substrate for a group III-V compound crystal according to Example 1.

### [Example 2]

A P-AlN ceramic substrate provided with a smooth bonding layer was obtained by the same method as in Example 1 (see paragraphs 0048 to 0052). Subsequently, a C-plane sapphire substrate having a diameter of 200 mm was selected as a seed crystal substrate to be thin-film transferred to the bonding layer. A general ion implantation device was used to implant H₂ ions into the C-plane sapphire substrate at a dose of 1.5 × 10¹⁷ atom/cm² up to a depth of 500 nm. The C-plane sapphire substrate subjected to the ion implantation was thin-film transferred to the bonding layer subjected to the thermal stabilization treatment and the polishing to form a processed layer having a thickness of 500 nm on the bonding layer, thereby producing a base substrate for a group III-V compound crystal according to Example 2. The C-plane sapphire substrate remaining after the peeling was recovered and reused as a seed crystal substrate for forming a processed layer.

The base substrate for a group III-V compound crystal according to Example 2 was a high-quality base substrate for a group III-V compound crystal having a large diameter, in which warpage, layer separation, cracks, etc. were not observed.

In order to evaluate the base substrate for a group III-V compound crystal according to Example 2, the following treatment was performed. First, in order to remove a damaged layer due to ion implantation on a surface of the C-plane sapphire substrate, the surface of the C-plane sapphire substrate was removed to a depth of about 150 nm by a polishing treatment. A GaN epitaxial layer having a thickness of 35 µm was directly formed on the processed layer by an MOCVD device. In this case, as in the effect evaluation of Example 1, the GaN epitaxial layer was also directly formed without laminating superlattice layers. As a result, no peeling or cracking occurred in the GaN epitaxial layer.

### [Comparative Example 1]

The ratio of SiH₄, O₂, NH₃, and N₂O was kept constant as SiH₄/O₂/NH₃/N₂O = 10/10/2/2 in terms of molar ratio from the start to the end of the film formation, the film formation was performed for 30 minutes, and a P-AlN ceramic substrate was sealed with an impurity encapsulating layer (having a composition represented by the composition formula SiOₓN_{y}) having a film thickness of 880 nm. The ratio of SiH₄, O₂, NH₃, and N₂O was kept constant as SiH₄/O₂/NH₃/N₂O = 10/10/5/5 in terms of molar ratio from the start to the end of the film formation, the film formation was performed for 3 hours, and a bonding layer (having a composition represented by the composition formula SiOₓN_{y}) having a film thickness of 6 µm was formed on the impurity encapsulating layer. Besides this, steps up to the step of forming the bonding layer on the impurity encapsulating layer were performed by the same method as that of the base substrate for a group III-V compound crystal according to Example 1. Quantitative analysis of each element of the impurity encapsulating layer (having the composition represented by the composition formula SiOₓN_{y}) was performed in a region near the P-AlN ceramic substrate at the start of the film formation and a region in the final portion of the film formation. As a result, the regions both had a SiO_{2.2}N_{1.6} composition. In addition, when quantitative analysis of each element of the bonding layer (having the composition represented by the composition formula SiOₓN_{y}) was performed, the composition in a region near the impurity encapsulating layer and the composition in a region in the final portion of the film formation were substantially the same, i.e., a SiO_{2.2}N_{2.1} composition.

However, when the P-AlN ceramic substrate was sealed with the impurity encapsulating layer, and then the bonding layer was further formed and subjected to a thermal stabilization treatment, a large number of voids were generated due to moisture absorption. In addition, layer separation occurred between the impurity encapsulating layer and the bonding layer. Therefore, the step of forming the processed layer on the bonding layer could not be performed. That is, in Comparative Example 1, a base substrate for a group III-V compound crystal could not be produced.

### Reference Signs List

1 base substrate for group III-V compound crystal
2 ceramic core layer
3 impurity encapsulating layer
4 bonding layer
5 processed layer
6 seed crystal substrate

## Claims

1. A base substrate for a group III-V compound crystal, comprising:
a ceramic core layer;
an impurity encapsulating layer configured to encapsulate the ceramic core layer;
a bonding layer on the impurity encapsulating layer; and
a processed layer on the bonding layer, wherein
the impurity encapsulating layer is a layer made of a composition represented by a composition formula SiOₓN_{y} (here, x = 0 to 2, y = 0 to 1.5, and x+y > 0),
the bonding layer is a layer made of a composition represented by a composition formula SiO_{x'}N_{y'} (here, x' = 1 to 2, and y' = 0 to 2), and
the processed layer is a seed crystal layer.

2. The base substrate for a group III-V compound crystal according to claim 1, wherein
the ceramic core layer is a polycrystalline AlN layer, and
the group III-V compound is a compound containing N and at least one group III element selected from the group consisting of Al, Ga, and In.

3. The base substrate for a group III-V compound crystal according to claim 1 or 2, wherein
values of x and y in the composition formula SiOₓN_{y} of the impurity encapsulating layer are different between a ceramic core layer side and a bonding layer side.

4. The base substrate for a group III-V compound crystal according to any one of claims 1 to 3, wherein
values of x' and y' in the composition formula SiO_{x'}N_{y'} of the bonding layer are different between an impurity encapsulating layer side and a processed layer side.

5. The base substrate for a group III-V compound crystal according to any one of claims 1 to 4, wherein
the processed layer contains a seed crystal made of at least one substance selected from the group consisting of Si, GaAs, SiC, AlN, GaN, and Al₂O₃.

6. A method for producing a base substrate for a group III-V compound crystal, comprising:
a step of forming an impurity encapsulating layer configured to encapsulate a ceramic core layer;
a step of forming a bonding layer on the impurity encapsulating layer; and
a step of forming a processed layer on the bonding layer, wherein
the impurity encapsulating layer is a layer made of a composition represented by a composition formula SiOₓN_{y} (here, x = 0.0 to 2.0, and y = 0.0 to 1.5),
the bonding layer is a layer made of a composition represented by a composition formula SiO_{x'}N_{y'} (here, x' = 1.0 to 2.0, and y' = 0.0 to 2.0), and
the processed layer is a seed crystal layer.

7. The method for producing a base substrate for a group III-V compound crystal according to claim 6, wherein
in the step of forming the processed layer, a seed crystal substrate is transferred to the bonding layer, and then the substrate is peeled off to form the processed layer.

8. The method for producing a base substrate for a group III-V compound crystal according to claim 6 or 7, wherein
the ceramic core layer is a polycrystalline AlN layer, and
the group III-V compound is a compound containing N and at least one group III element selected from the group consisting of Al, Ga, and In.

9. The method for producing a base substrate for a group III-V compound crystal according to any one of claims 6 to 8, wherein
in the step of forming the impurity encapsulating layer, the impurity encapsulating layer is formed such that values of x and y in the composition formula SiOₓN_{y} of the impurity encapsulating layer are different between a ceramic core layer side and a bonding layer side.

10. The method for producing a base substrate for a group III-V compound crystal according to any one of claims 6 to 9, wherein
in the step of forming the bonding layer, the bonding layer is formed such that values of x' and y' in the composition formula SiO_{x'}N_{y'} of the bonding layer are different between an impurity encapsulating layer side and a processed layer side.

11. The method for producing a base substrate for a group III-V compound crystal according to any one of claims 6 to 10, further comprising:
a step of thermally stabilizing at least one of the ceramic core layer, the impurity encapsulating layer, and the bonding layer; and
a step of polishing a surface of the thermally stabilized layer.

12. The method for producing a base substrate for a group III-V compound crystal according to any one of claims 6 to 11, wherein
in the step of forming the processed layer, the processed layer is formed by performing ion implantation on a seed crystal substrate made of at least one substance selected from the group consisting of Si, GaAs, SiC, AlN, GaN, and Al₂O₃, transferring the substrate subjected to the ion implantation to the bonding layer, and peeling off the transferred substrate.
